# EUROPEAN PATENT APPLICATION

(11) **EP 4 772 905 A1**
(43) Date of publication of application: **08.07.2026**
(21) Application number: 24867359.2
(22) Date of filing: 12.09.2024
(51) Int. Cl.: G01S 7/484, H01S 5/40, G01S 17/02

(54) **LIGHT-EMITTING DEVICE AND MANUFACTURING METHOD THEREFOR, RADAR AND ELECTRONIC DEVICE**

(30) Priority: 18.09.2023 CN 202311204360
(71) Applicant: HUAWEI TECHNOLOGIES CO., LTD., Shenzhen 518129 (CN)
(72) Inventor: WU, Zhiwei, Shenzhen, Guangdong 518129 (CN); LIU, Junzhe, Shenzhen, Guangdong 518129 (CN); ZHANG, Jiaqi, Shenzhen, Guangdong 518129 (CN); LU, Xingdong, Shenzhen, Guangdong 518129 (CN); YU, Hongping, Shenzhen, Guangdong 518129 (CN); XIE, Chengzhi, Shenzhen, Guangdong 518129 (CN); WANG, Zhongyan, Shenzhen, Guangdong 518129 (CN)
(74) Representative: Körber, Martin Hans
(86) International application number: PCT/CN2024/118633
(87) International publication number: WO 2025/060950

(57) **Abstract**

A light-emitting component and a manufacturing method thereof, a radar, and an electronic device are provided. The light-emitting component includes a plurality of light-emitting units (m0), a first insulation layer (102) is disposed in a first trench (n1) between two light-emitting units (m0) and on the light-emitting unit (m0), an insulation filling portion (107) is disposed on the first insulation layer (102) in the first trench (n1), and a second electrode layer (101) covers the insulation filling portion (107). In this way, a distance between the second electrode layer (101) in the first trench (n1) and a first semiconductor layer (103) can be increased. Even if a high reverse bias voltage is applied, the high reverse bias voltage is withstood by the first insulation layer (102) and the insulation filling portion (107) together. Even if the first insulation layer (102) formed in the first trench (nl) has defects or poor deposition effect, presence of the insulation filling portion (107) can compensate for these defects and deficiencies, thereby further improving a capability of withstanding the high reverse bias voltage and further preventing breakdown of the first insulation layer (102), to improve reliability of the light-emitting component.

## Description

### CROSS-REFERENCE TO RELATED APPLICATIONS

This application claims priority to Chinese Patent Application No. 202311204360.9, filed with the China National Intellectual Property Administration on September 18, 2023 and entitled "LIGHT-EMITTING COMPONENT AND MANUFACTURING METHOD THEREOF, RADAR, AND ELECTRONIC DEVICE", which is incorporated herein by reference in its entirety.

### TECHNICAL FIELD

This application relates to the field of radar technologies, and in particular, to a light-emitting component and a manufacturing method thereof, a radar, and an electronic device.

### BACKGROUND

With the development of science and technology, in an increasing quantity of scenarios, a lidar (light detection and ranging, LiDAR) needs to be used for detection. For example, the lidar is used to sense an ambient environment, and identify and track a target. An operating principle of the lidar is as follows: The lidar transmits an electromagnetic wave to the target, and the electromagnetic wave is irradiated to the target and then returns to form an echo. A round-trip time of the wave may be calculated based on the transmitted electromagnetic wave and the echo, to depict a distance to the target and a shape of the target. A manner of driving a light-emitting component in the lidar generally includes low-side drive. The low-side drive has a stronger driving capability and lower power consumption, but the low-side drive causes the light-emitting component to be in a high reverse bias voltage state for a long time, and this brings challenges to reliability of the light-emitting component and even the radar.

### SUMMARY

This application provides a light-emitting component and a manufacturing method thereof, a radar, and an electronic device, to improve reliability of the light-emitting component and even the radar.

According to a first aspect, an embodiment of this application provides a light-emitting component. The light-emitting component may include: a first electrode layer, a first semiconductor layer disposed on the first electrode layer, and a light-emitting unit, a first insulation layer, an insulation filling portion, and a second electrode layer that are disposed on the first semiconductor layer. There are a plurality of light-emitting units that are spaced apart, the light-emitting unit is electrically connected to the second electrode layer, a first trench is formed in a region between two light-emitting units, and the first insulation layer is disposed on each of a trench bottom and a trench wall of the first trench and a side that is of the light-emitting unit and that faces away from the first semiconductor layer. The insulation filling portion is disposed on a surface on a side that is of the first insulation layer in the first trench and that faces away from the first semiconductor layer, and the second electrode layer covers the insulation filling portion, that is, the second electrode layer may cover the insulation filling portion in the first trench. In this way, the insulation filling portion is disposed on the first insulation layer in the first trench, so that a distance between the second electrode layer in the first trench and the first semiconductor layer can be increased. Even if a high reverse bias voltage is applied, the high reverse bias voltage is withstood by the first insulation layer and the insulation filling portion together. Even if the first insulation layer formed in the first trench has defects or poor deposition effect, presence of the insulation filling portion can compensate for these defects and deficiencies, thereby further improving a capability of withstanding the high reverse bias voltage and further preventing breakdown of the first insulation layer, to improve reliability of the light-emitting component.

It should be understood that a quantity of light-emitting units that are disposed is not limited herein, and may be set according to an actual requirement. The light-emitting units may be arranged in rows and columns, or may be arranged as required. In this case, the two light-emitting units that form the first trench may be two light-emitting units that are adjacent in a row direction, two light-emitting units that are adjacent in a column direction, or two light-emitting units that are adjacent on a diagonal. In addition, when the second electrode layer covers the insulation filling portion, the second electrode layer may completely cover the insulation filling portion or partially cover the insulation filling portion. Moreover, the light-emitting component of the foregoing structure may be considered as a vertical cavity surface light-emitting component. Certainly, for another light-emitting component that needs to be in a reverse bias state for a long time, the concept in this solution may be used. To be specific, the insulation filling portion is disposed between an insulation layer and an electrode layer, to improve a capability of withstanding a reverse bias voltage, prevent breakdown of the insulation layer, and improve the reliability of the light-emitting component.

Further, because the insulation filling portion is disposed on the first insulation layer in the first trench, and the insulation filling portion may compensate for the defects and the deficiencies in the first insulation layer, a thickness of the first insulation layer may be set to be small. For example, the thickness of the first insulation layer may be set to 0.05 µm to 2 µm. In this way, even if the first insulation layer is set to be thin, the presence of the insulation filling portion can still prevent breakdown of the first insulation layer in the first trench, so that a thickness of the light-emitting component can be further reduced while the reliability of the light-emitting component is improved. In addition, because the first insulation layer may be set to be thin, manufacturing difficulty of the light-emitting component can be reduced, and manufacturing costs of the light-emitting component can be reduced.

For example, the light-emitting component may further include a peripheral structure. The peripheral structure is disposed on the first semiconductor layer, the peripheral structure is of an enclosed structure with internal accommodation space, and each light-emitting unit is disposed in the accommodation space, so that the peripheral structure encloses all of the light-emitting units. In this case, the second trench may be formed in a region between the peripheral structure and the light-emitting unit. In other words, the second trench is formed in a region between a light-emitting unit adjacent to the peripheral structure and the peripheral structure. The first insulation layer is disposed on each of a side that is of the peripheral structure and that faces away from the first semiconductor layer, and a trench bottom and a trench wall of the second trench. The insulation filling portion is disposed on a surface on a side that is of the first insulation layer in the second trench and that faces away from the first semiconductor layer, and the second electrode layer covers both the insulation filling portion in the first trench and the insulation filling portion in the second trench. Therefore, at a position of the second trench, the high reverse bias voltage can still be withstood by the first insulation layer and the insulation filling portion together. Even if the first insulation layer formed in the second trench has defects or poor deposition effect, presence of the insulation filling portion can compensate for these defects and deficiencies, so that a capability of the first insulation layer in the second trench to withstand the high reverse bias voltage can be improved, thereby preventing breakdown of the first insulation layer in the second trench, to further improve the reliability of the light-emitting component.

In addition, when the second electrode layer includes a connection electrode disposed in a region in which the peripheral structure is disposed, the light-emitting component further includes a control circuit, and the control circuit is electrically connected to the connection electrode, the insulation filling portion may also be disposed between the first insulation layer disposed on the peripheral structure and the connection electrode. In this way, the second electrode layer can also cover the insulation filling portion, and a distance between the connection electrode and the first insulation layer can be further increased. The insulation filling portion compensates for a defect and a deficiency in the first insulation layer on the peripheral structure, so that a voltage can be withstood by the first insulation layer and the insulation filling portion together, to increase a capability of the first insulation layer on the peripheral structure to withstand the voltage, and prevent breakdown of the first insulation layer on the peripheral structure, thereby further improving the reliability of the light-emitting component. In addition, it is found through an experimental test that a probability that the light-emitting component in which the insulation filling portion is disposed is broken down at a high reverse bias voltage may be effectively reduced or even reduced to 0, to effectively resolve a problem of breakdown at the high reverse bias voltage.

If the control circuit is disposed in the region in which the peripheral structure is located, it indicates that the control circuit and the light-emitting unit are disposed on a same substrate. This can achieve an integrated design of the light-emitting component. In addition, because the peripheral structure is not used for light emitting, the control circuit is disposed in the region in which the peripheral structure is located. This can avoid occupying an area of a region in which the light-emitting unit is located, thereby avoiding affecting light-emitting effect of the light-emitting component. Moreover, the control circuit may be disposed on a side that is of the connection electrode and that faces away from the peripheral structure, a third insulation layer is disposed between the control circuit and the connection electrode, and the control circuit is electrically connected to the connection electrode through a through hole in the third insulation layer, so that the control circuit is electrically connected to the connection electrode.

Certainly, the control circuit and the light-emitting unit may alternatively be disposed on different substrates. In other words, the light-emitting component may include a first part and a second part. All the peripheral structure, the light-emitting unit, the first insulation layer, the insulation filling portion, the first electrode layer, the second electrode layer, and the first semiconductor layer may be disposed in the first part, and the control circuit is disposed in the second part. In this way, the control circuit may be prevented from occupying an area of the first part, so that more space of the first part can be reserved for disposing the light-emitting unit, to improve a resolution of the light-emitting component. In this case, the first part may be connected to the second part through a chip on film or another structure, so that the control circuit is bound and connected to the connection electrode. Further, the connection electrode may be a pad, and a structure form of the pad may be designed according to an actual requirement. This is not limited herein.

In addition, for example, structures of the light-emitting unit and the peripheral structure may be basically similar. For example, the light-emitting unit and the peripheral structure may each include the first semiconductor layer, a light-emitting layer, and a second semiconductor layer that are stacked in a direction from the first electrode layer to the second electrode layer. The light-emitting unit may further include an auxiliary electrode disposed on a surface on a side that is of the second semiconductor layer and that faces away from the light-emitting layer. An auxiliary electrode in each light-emitting unit is connected to the second electrode layer, so that the light-emitting unit is electrically connected to the second electrode layer. When the second electrode layer is entirely disposed, to enable the light-emitting unit to emit light outward, a plurality of openings may be provided in the second electrode layer, the opening is provided corresponding to the light-emitting unit, and each light-emitting unit may emit light outward through a corresponding opening. There may be one or more openings corresponding to each light-emitting unit. This is not limited herein, provided that the light-emitting unit can emit light outward through the corresponding opening. It should be understood that, that the second electrode layer is entirely disposed may be understood as that the second electrode layer is entirely disposed on the first semiconductor layer, so that each light-emitting unit, the peripheral structure, the first insulation layer, and the insulation filling portion are all disposed between the first semiconductor layer and the second electrode layer, and the connection electrode may be considered as a part that is of the second electrode layer and that is located on the peripheral structure. In addition, because the peripheral structure does not need to emit light outward, there is no need to dispose the auxiliary electrode, and the second electrode layer does not need to be provided with the opening in a region in which the peripheral structure is located, to simplify a structure of the light-emitting component.

For the light-emitting component, polarities of charges transmitted by the first semiconductor layer and the second semiconductor layer may be different. For example, the charge transmitted by the first semiconductor layer may be a positive charge, and correspondingly, the charge transmitted by the second semiconductor layer is a negative charge. In this case, the first semiconductor layer may provide the positive charge for the light-emitting layer, the second semiconductor layer may provide the negative charge for the light-emitting layer, and the positive charge and the negative charge meet in the light-emitting layer to generate photons and emit light. Certainly, the charge transmitted by the first semiconductor layer may alternatively be a negative charge, and correspondingly, the charge transmitted by the second semiconductor layer is a positive charge. In this case, the first semiconductor layer may provide the negative charge for the light-emitting layer, the second semiconductor layer may provide the positive charge for the light-emitting layer, and the positive charge and the negative charge meet in the light-emitting layer to generate photons and emit light. Manufacturing materials of the first semiconductor layer, the second semiconductor layer, and the light-emitting layer may be selected according to an actual requirement. This is not limited herein. Any manufacturing material that can implement the first semiconductor layer, the second semiconductor layer, and the light-emitting layer falls within the protection scope of this embodiment of this application.

In the light-emitting component, a second insulation layer may be further disposed between the second electrode layer and the insulation filling portion, so that the insulation filling portion is disposed between the first insulation layer and the second insulation layer. When the insulation filling portion is made of a polymer material, and the second insulation layer is made of an inorganic insulating material, the second insulation layer may increase a bonding force between the insulation filling portion and the second electrode layer, to prevent the insulation filling portion from being separated from the second electrode layer due to a poor bonding force when the insulation filling portion is in direct contact with the second electrode layer, so that the reliability of the light-emitting component can be improved. Certainly, when the first insulation layer is made of an inorganic insulating material, the first insulation layer may also increase a bonding force between the insulation filling portion and the first semiconductor layer, to improve the reliability of the light-emitting component.

The first insulation layer and the second insulation layer may include a same manufacturing material, and the manufacturing material may be an inorganic insulating material, for example, but not limited to, SiN, SiO₂, or TiN. This may be specifically selected based on an actual situation, and is not limited herein. A manufacturing material of the insulation filling portion may include an insulating material including at least one of C, O, and Si, for example, but not limited to, a polymer material or an inorganic insulating material. The polymer material may include but is not limited to polybenzoxazole, polyimide, benzocyclobutene, or the like, and the inorganic insulating material may include but is not limited to aluminum oxide, silicon oxynitride, silicate, nitrate, or the like. This may be specifically selected based on an actual situation, and is not limited herein.

For example, a thickness of the insulation filling portion may be set to 3 µm to 10 µm. The thickness of the insulation filling portion may be set based on factors such as a disposition position, a requirement for a breakdown voltage, and manufacturing costs. For example, if the requirement for the breakdown voltage is high, the thickness of the insulation filling portion may be set to be slightly larger. If the requirement for the breakdown voltage is low, but a requirement for the manufacturing costs is high, the thickness of the insulation filling portion may be set to be slightly smaller. For the insulation filling portion disposed between the connection electrode and the first insulation layer, when the connection electrode is used as the pad, because the pad usually needs to be welded, the insulation filling portion may be set to be thicker, to avoid damage to the first insulation layer below the connection electrode during welding. Alternatively, when the control circuit is disposed on the side that is of the connection electrode and that faces away from the peripheral structure, and the control circuit is connected to the connection electrode through the through hole, the insulation filling portion may be disposed slightly thinner, to avoid a large thickness of the light-emitting component and avoid increasing a size of the light-emitting component. In addition, the manufacturing costs may be further reduced due to a small thickness of the insulation filling portion. Certainly, regardless of a position at which the insulation filling portion is disposed, a larger thickness of the insulation filling portion indicates a stronger voltage withstand capability, so that the reliability of the light-emitting component is higher.

According to a second aspect, an embodiment of this application further provides a manufacturing method for a light-emitting component. The manufacturing method may be used to manufacture the light-emitting component described in the first aspect and any one of embodiments of the first aspect. The manufacturing method may include: forming the first electrode layer; forming the first semiconductor layer on the first electrode layer; forming, on the first semiconductor layer, the plurality of light-emitting units that are spaced apart, and forming the first trench in the region between two light-emitting units; forming the first insulation layer at least on the trench bottom and the trench wall of the first trench and the light-emitting unit; forming the insulation filling portion at least on the first insulation layer in the first trench; and forming the second electrode layer, so that the second electrode layer covers the insulation filling portion, and the second electrode layer is electrically connected to the light-emitting unit. In this way, the insulation filling portion is disposed on the first insulation layer in the first trench, so that a distance between the second electrode layer in the first trench and the first semiconductor layer can be increased. Even if a high reverse bias voltage is applied, the high reverse bias voltage is withstood by the first insulation layer and the insulation filling portion together. Even if the first insulation layer formed in the first trench has defects or poor deposition effect, presence of the insulation filling portion can compensate for these defects and deficiencies, thereby further improving a capability of withstanding the high reverse bias voltage and further preventing breakdown of the first insulation layer, to improve reliability of the light-emitting component.

The insulation filling portion may be formed in the following two manners.

Manner 1: Deposit a liquid insulating material at least on the first insulation layer in the first trench, to form an initial film; and then perform curing processing on the initial film, to form the solid insulation filling portion. When the insulation filling portion is made by using the liquid insulating material, because the liquid insulating material has good fluidity, before curing, the insulating material may be well filled into every corner of the first insulation layer, to be filled into a hole, a gap, and a defect in the first insulation layer, and may further cover an impurity in the first insulation layer. Therefore, the defect and a deficiency in the first insulation layer can be well compensated, and an anti-breakdown capability and a voltage withstand capability can be improved, so that reliability of the light-emitting component can be improved. The liquid insulating material may be deposited through spin coating. In addition, during spin coating, a thickness of the obtained initial film may be controlled by controlling a rotational speed during spin coating, so that a thickness of the insulation filling portion can be controlled. For example, a larger rotational speed indicates a smaller thickness of the initial film and a smaller thickness of the insulation filling portion, and vice versa. In Manner 1, the liquid insulating material may be a liquid polymer material.

Manner 2: Deposit an insulating material at least on the first insulation layer in the first trench by using a vapor deposition method, to form the solid insulation filling portion. When the vapor deposition method is used, the insulating material may be processed as a vapor-phase atom or molecule. Because a size of the vapor-phase atom or molecule is small, the vapor-phase atom or molecule may be well filled into a hole, a gap, and a defect in the first insulation layer, and may further cover an impurity in the first insulation layer. Therefore, the defect and a deficiency in the first insulation layer can be well compensated, and an anti-breakdown capability and a voltage withstand capability can be improved, so that reliability of the light-emitting component can be improved. In Manner 2, the used insulating material may be an inorganic insulating material, for example, aluminum oxide, silicon oxynitride, silicate, or nitrate.

Certainly, in an actual case, when the insulation filling portion is manufactured, Manner 1 or Manner 2 may be selected according to an actual requirement, to meet design requirements of different application scenarios.

For example, the manufacturing method may further include: when the light-emitting unit is formed, forming the peripheral structure enclosing all of the light-emitting units. In other words, when the light-emitting unit is formed, the peripheral structure may be further formed, so that the light-emitting unit and the peripheral structure may be obtained in a same manufacturing process. There is a second trench between the peripheral structure and the light-emitting unit. Therefore, in addition to being disposed in the first trench and on the light-emitting unit, the first insulation layer may be further disposed on a trench bottom and a trench wall of the second trench and on the peripheral structure. In this case, when the insulation filling portion is formed, the following may be specifically included: forming the insulation filling portion on the first insulation layer in the first trench and the second trench and on at least a part of the first insulation layer located in the region in which the peripheral structure is located. In this way, breakdown of the first insulation layer in the first trench and the second trench and the first insulation layer on the peripheral structure can be prevented, so that the reliability of the light-emitting component can be improved through the insulation filling portion.

In addition, the manufacturing method may further include: after the insulation filling portion is formed and before the second electrode layer is formed, forming the second insulation layer on the insulation filling portion, so that the insulation filling portion is disposed between the first insulation layer and the second insulation layer, and the insulation filling portion is in contact with the second electrode layer through the second insulation layer, thereby improving bonding strength of the insulation filling portion and the second electrode layer and improving the reliability of the light-emitting component.

Moreover, when the second electrode layer is formed, the following may be specifically included: entirely depositing the conductive layer if the second insulation layer is disposed, so that the conductive layer covers the light-emitting unit, the peripheral structure, and the second insulation layer; and then performing patterning processing on the conductive layer, and forming, on the conductive layer, the opening provided corresponding to the light-emitting unit, to form the second electrode layer. A method for depositing the conductive layer may be but is not limited to an electroplating method, the vapor deposition method, or the like.

It should be understood that a problem-resolving principle of the light-emitting component manufactured by using the manufacturing method is similar to the problem-resolving principle of the foregoing light-emitting component. Therefore, for implementation and technical effect of the manufacturing method, refer to the implementation and technical effect of the foregoing light-emitting component. Repeated descriptions are not described again.

According to a third aspect, an embodiment of this application further provides a radar. The radar may include a detector, a controller, and the light-emitting component described in the first aspect and any one of embodiments of the first aspect. The light-emitting component is configured to transmit an electromagnetic wave to a target under control of the controller. The detector is configured to: receive an echo reflected from the target and transmit the echo to the controller. The controller is configured to determine information about the target based on the electromagnetic wave transmitted by the light-emitting component and the echo detected by the detector. In this way, reliability of the radar can also be improved while reliability of the light-emitting component is improved. In addition, information detection accuracy of the radar can be further improved, and misjudgments can be reduced. It should be understood that the information that is about the target and that is determined by the controller may include other information related to the target, for example, position information of the target, shape information of the target, and a moving speed of the target. In addition, light is an electromagnetic wave, or light is a radiation form of an electromagnetic wave. Therefore, that the light-emitting component emits light is essentially that the light-emitting component transmits an electromagnetic wave.

For example, the detector may be a component that can detect an echo. A specific structure of the component may be any structure that can implement a function of the detector and that is well known by a person skilled in the art. This is not limited herein. In addition, the controller may be a component that has a control function, for example, a central processing unit (Central Processing Unit, CPU) or a microcontroller unit (Microcontroller Unit, MCU), and may be specifically selected according to an actual requirement. This is not limited herein.

In addition, the radar in this embodiment of this application may be classified into an over-the-horizon radar, a microwave radar, a millimeter-wave radar, and a lidar based on a frequency band of an electromagnetic wave. When the radar is an over-the-horizon radar, an electromagnetic wave transmitted by the light-emitting component belongs to an over-the-horizon frequency band. When the radar is a microwave radar, an electromagnetic wave transmitted by the light-emitting component belongs to a microwave frequency band. When the radar is a millimeter-wave radar, an electromagnetic wave transmitted by the light-emitting component belongs to a millimeter-wave frequency band. When the radar is a lidar, an electromagnetic wave transmitted by the light-emitting component belongs to a laser frequency band.

It should be understood that a problem-resolving principle of the radar is similar to the problem-resolving principle of the foregoing light-emitting component. Therefore, for implementation and technical effect of the radar, refer to the implementation and technical effect of the foregoing light-emitting component. Repeated descriptions are not described again.

According to a fourth aspect, an embodiment of this application further provides an electronic device. The electronic device may include a control device and the radar described in the third aspect and any one of embodiments of the third aspect, and the radar is disposed on the control device. The control device may be a mobile device or a fixed device. The mobile device may include but is not limited to an intelligent transportation device or the like, for example, a vehicle, an uncrewed aerial vehicle, an unmanned ground vehicle, or a robot. The fixed device may include but is not limited to an intelligent communication device, a smart home device, an intelligent manufacturing device, or the like, for example, a measurement and control station.

It should be understood that a problem-resolving principle of the electronic device is similar to the problem-resolving principle of the foregoing radar. Therefore, for implementation and technical effect of the electronic device, refer to the implementation and technical effect of the foregoing radar. Repeated descriptions are not described again.

### BRIEF DESCRIPTION OF DRAWINGS

FIG. 1 is a diagram of a structure of an electronic device according to an embodiment of this application;
FIG. 2 is a diagram of a structure of a radar according to an embodiment of this application;
FIG. 3 is a diagram of an operating principle of a radar according to an embodiment of this application;
FIG. 4 is a schematic of a circuit structure of a light-emitting component according to an embodiment of this application;
FIG. 5 is a top view of a light-emitting component according to an embodiment of this application;
FIG. 6 is a sectional view of FIG. 5 in an x1-x2 direction;
FIG 7A to FIG. 7C are diagrams of a function principle of an insulation filling portion according to an embodiment of this application;
FIG. 8 is a sectional view of FIG. 5 in an x3-x4 direction;
FIG. 9 is a sectional view of a partial structure shown in FIG. 5 in an x1-x2 direction;
FIG. 10 is another sectional view of FIG. 5 in an x3-x4 direction;
FIG. 11 is a top view of another light-emitting component according to an embodiment of this application;
FIG. 12 is a diagram of a test result of a reverse bias leakage current of a light-emitting component according to an embodiment of this application;
FIG 13A to FIG. 13E are a flowchart of a manufacturing method for a light-emitting component according to an embodiment of this application; and
FIG 14A to FIG. 14F are a flowchart of another manufacturing method for a light-emitting component according to an embodiment of this application.

### Reference numerals:

100: light-emitting component; 200: controller; 300: detector; 101: second electrode layer; 102: first insulation layer; 103: first semiconductor layer; 104: second insulation layer; 105: third insulation layer; 106: first electrode layer; 107: insulation filling portion; 110: direct voltage source; 111 and 112: switches; 114: capacitor; 115: driver; 116: transistor; 117: node; 120: impurity particle; 121: hole; m0: light-emitting unit; m01: light-emitting layer; m02: second semiconductor layer; m03: auxiliary electrode; m1: peripheral structure; m2: connection electrode; m3: control circuit; m4: opening; m5: chip on film; n1: first trench; n2: second trench; n11: trench bottom; n12: trench wall; f1: first part; f2: second part.

### DESCRIPTION OF EMBODIMENTS

To make objectives, technical solutions, and advantages of this application clearer, the following further describes this application in detail with reference to accompanying drawings.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

For ease of understanding the technical solutions provided in embodiments of this application, the following first describes an application scenario of the technical solutions.

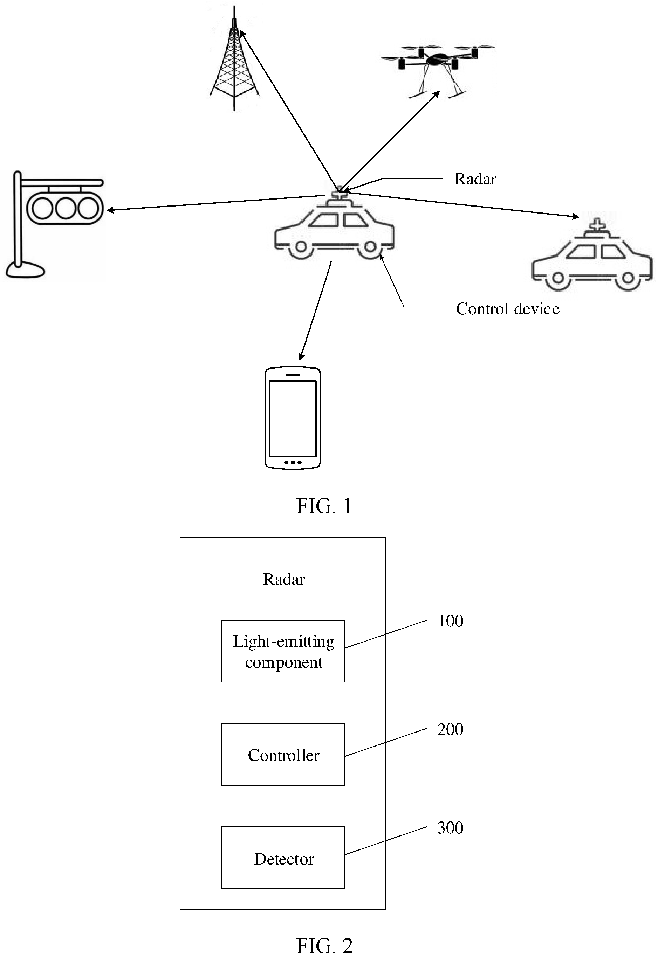

Radars may be widely used in various electronic devices. FIG. 1 is a diagram of an example of a structure of a radar used in an electronic device. Refer to FIG. 1. The electronic device includes a control device and the radar, and the radar is disposed on the control device. The control device may be a mobile device or a fixed device. The mobile device may include but is not limited to an intelligent transportation device or the like, for example, a vehicle, an uncrewed aerial vehicle, an unmanned ground vehicle, or a robot. The fixed device may include but is not limited to an intelligent communication device, a smart home device, an intelligent manufacturing device, or the like, for example, a measurement and control station.

In an optional application scenario of this application, the radar may be mounted on the mobile device. For example, in this application, when the radar is used in an autonomous driving scenario, or may be used in a networked vehicle scenario or the like, the radar may be mounted on a vehicle and used as a vehicle-mounted radar, as shown in FIG. 1. For another example, the radar may be mounted on an aircraft and used as an airborne radar. In an optional application scenario of this application, the radar may be further mounted on a mobile platform, for example, a satellite. In this case, the radar requires assistance of another apparatus on the mobile platform to determine a current position and steering information of the radar. This can ensure availability of measurement data. In an optional application scenario of this application, the radar may also be mounted on a fixed platform. For example, the radar may be mounted on a roadside unit (roadside unit, RSU), a roof, a base station, or the like. In a scenario in which the radar is mounted on the fixed platform, the radar requires assistance of another apparatus on the fixed platform to determine a current position and steering information of the radar. This can ensure availability of measurement data. In addition, the radar in this application may be further used in another possible scenario. Details are not enumerated herein.

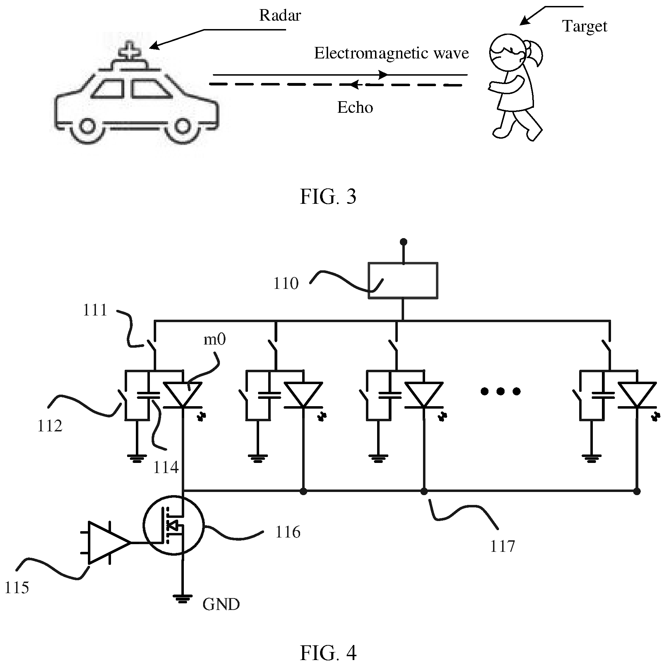

Moreover, the radar may include an over-the-horizon radar, a microwave radar, a millimeter-wave radar, a lidar, or the like based on a frequency band of an emitted electromagnetic wave. Regardless of a type of radar, a structure included in the radar is basically similar. FIG. 2 is a diagram of an example of a structure of a radar according to this application. Refer to FIG. 2. The radar includes a light-emitting component 100, a detector 300, and a controller 200. The light-emitting component 100 is configured to transmit an electromagnetic wave to a target under control of the controller 200. The detector 300 is configured to receive an echo reflected from the target and transmit the echo to the controller 200. The controller 200 is configured to determine information about the target based on the electromagnetic wave transmitted by the light-emitting component 100 and the echo detected by the detector 300. In other words, with reference to a principle diagram shown in FIG. 3, the radar may transmit the electromagnetic wave to the target, and the electromagnetic wave is irradiated to the target and then returns to form the echo. A round-trip time of the wave may be calculated based on the transmitted electromagnetic wave and the echo, to depict a distance to the target and a shape of the target. The determined information about the target may include but is not limited to information such as position information, shape information, and a moving speed of the target. It should be understood that light emitted by the light-emitting component belongs to an electromagnetic wave, and a type of electromagnetic wave transmitted by the light-emitting component may be controlled and implemented by the controller.

A manner of driving the light-emitting component generally includes high-side drive and low-side drive. A solution of the high-side drive is mature, but performance of the high-side drive is mediocre. The low-side drive has excellent performance, but the low-side drive causes the light-emitting component to be in a high reverse bias voltage state for a long time, and this brings challenges to long-term reverse bias reliability of the light-emitting component. Refer to a schematic of a circuit structure of a light-emitting component shown in FIG. 4. A specific low-side drive process may include the following steps.

When a switch 111 is turned on, a switch 112 is turned off, and a driver 115 controls a transistor 116 to be cut off, a voltage signal provided by a direct voltage source 110 is provided for a capacitor 114 to charge the capacitor 114. When the switch 111 is turned off, the switch 112 is turned on, and the driver 115 controls the transistor 116 to be conducted, the capacitor 114, a light-emitting unit m0, and a ground end GND form a path, the capacitor 114 discharges, and provides a first voltage for a positive electrode of the light-emitting unit m0, the ground end GND provides a second voltage (for example, 0 V) for a negative electrode of the light-emitting unit m0, and when the first voltage is greater than the second voltage, the light-emitting unit m0 emits light. When light-emitting units m0 are connected in parallel, the light-emitting units m0 sequentially emit light. In this case, when a 1^{st} light-emitting unit m0 on a left side in FIG. 4 emits light, all other light-emitting units m0 are in a non-emitting state, so that the light-emitting units m0 can illuminate different regions of the target, thereby achieving a region-based scanning process.

However, when the 1^{st} light-emitting unit m0 on the left side in FIG. 4 emits the light, and all the other light-emitting units m0 are in the non-emitting state, a node 117 has a specific positive potential, and potentials of positive electrodes of the other light-emitting units m0 are close to the second voltage, for example, 0 V. As a result, the 1^{st} light-emitting unit m0 on the left side in FIG. 4 is in a forward bias state, the other light-emitting units m0 are in a reverse bias state, a current cannot pass through the other light-emitting units m0, and a voltage difference is formed between two ends of the other light-emitting units m0. If the voltage difference is large, and the other light-emitting units m0 are in a high reverse bias state for a long time, this poses a great challenge to reliability of the light-emitting component.

Based on this, this application provides a light-emitting component and a manufacturing method thereof, a radar, and an electronic device, to improve reliability of the light-emitting component and even the radar.

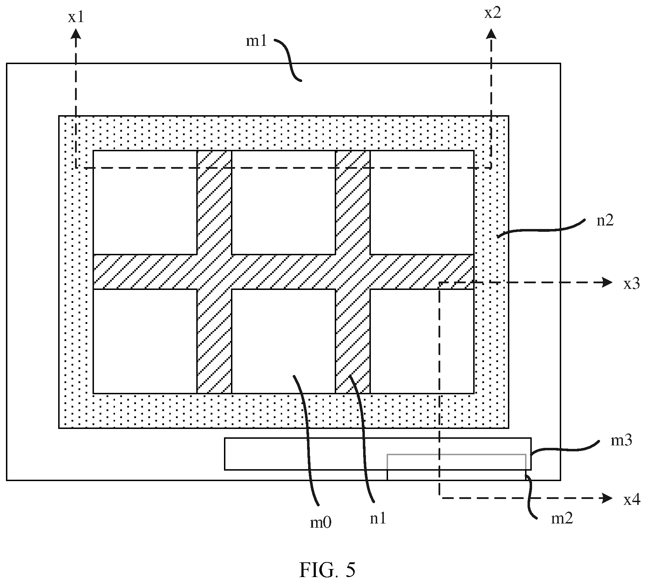

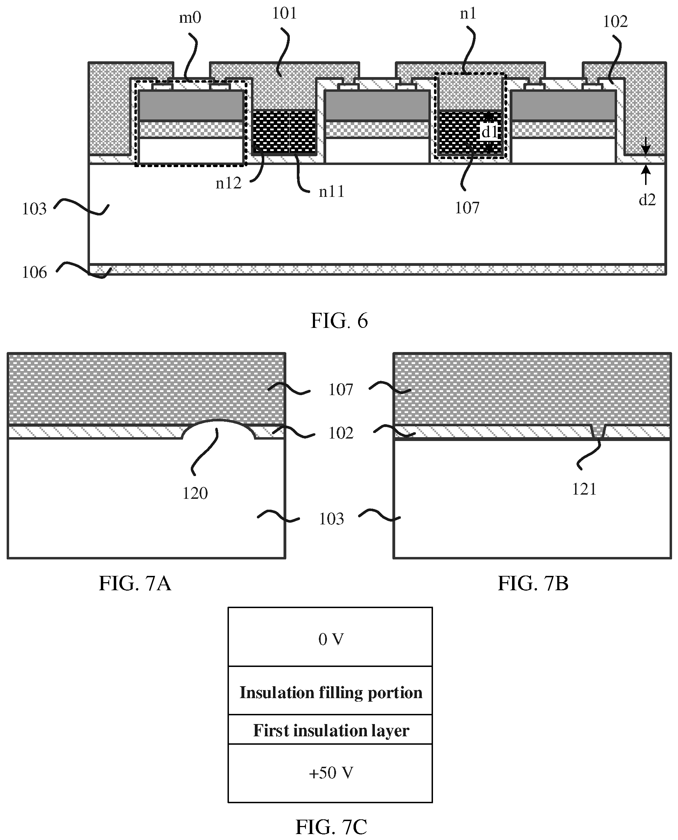

FIG. 5 and FIG. 6 are diagrams of an example of a structure of a light-emitting component according to an embodiment of this application. As shown in FIG. 5 and FIG. 6, the light-emitting component may include: a first electrode layer 106, a first semiconductor layer 103 disposed on the first electrode layer 106, and a light-emitting unit m0, a first insulation layer 102, an insulation filling portion 107, and a second electrode layer 101 that are disposed on the first semiconductor layer 103. There are a plurality of light-emitting units m0 that are spaced apart, the light-emitting unit m0 is electrically connected to the second electrode layer 101, a first trench n1 is formed in a region between two light-emitting units m0, and the first insulation layer 102 is disposed on each of a trench bottom n11 and a trench wall n12 of the first trench n1 and a side that is of the light-emitting unit m0 and that faces away from the first semiconductor layer 103. The insulation filling portion 107 is disposed on a surface on a side that is of the first insulation layer 102 in the first trench n1 and that faces away from the first semiconductor layer 103, and the second electrode layer 101 covers the insulation filling portion 107 in the first trench n1. It should be understood that, in FIG. 5, a region filled with diagonal lines represents the first trench n1, and a region filled with sparse black spots represents the second trench n2.

In other words, as shown in FIG. 7A to FIG. 7C, FIG. 7A indicates that the insulation filling portion 107 may cover an impurity particle 120 in the first insulation layer 102, FIG. 7B indicates that the insulation filling portion 107 may fill a hole 121 in the first insulation layer 102, and FIG. 7C indicates that a reverse bias voltage is withstood by the first insulation layer 102 and the insulation filling portion 107 together. It should be understood that the reverse bias voltage withstood by the first insulation layer 102 and the insulation filling portion 107 together is not limited to 50 V. 50 V is merely used as an example for description herein. In this way, the insulation filling portion 107 is disposed, so that a distance between the second electrode layer 101 in the first trench n1 and the first semiconductor layer 103 can be increased. Even if a high reverse bias voltage is applied, the high reverse bias voltage is withstood by the first insulation layer 102 and the insulation filling portion 107 together. Even if the first insulation layer 102 formed in the first trench n1 has defects or poor deposition effect, presence of the insulation filling portion 107 can compensate for these defects and deficiencies, thereby further improving a capability of withstanding the high reverse bias voltage and further preventing breakdown of the first insulation layer 102, to improve reliability of the light-emitting component. Particularly, when a thickness d1 of the insulation filling portion 107 is large, for example, when the thickness d1 is greater than 5 µm, a voltage withstood by the insulation filling portion 107 and the first insulation layer 102 together may reach up to 200 V, so that a voltage withstand capability of the light-emitting component is effectively improved.

Further, because the insulation filling portion 107 is disposed on the first insulation layer 102 in the first trench n1, and the insulation filling portion 107 may compensate for the defects and the deficiencies in the first insulation layer 102, a thickness d2 of the first insulation layer 102 may be set to be small. For example, the thickness d2 of the first insulation layer 102 may be set to 0.05 µm to 2 µm. In this way, even if the first insulation layer 102 is set to be thin, the presence of the insulation filling portion 107 can still prevent breakdown of the first insulation layer 102 in the first trench n1, so that a thickness of the light-emitting component can be further reduced while the reliability of the light-emitting component is improved. In addition, because the first insulation layer 102 may be set to be thin, manufacturing difficulty of the light-emitting component can be reduced, and manufacturing costs of the light-emitting component can be reduced.

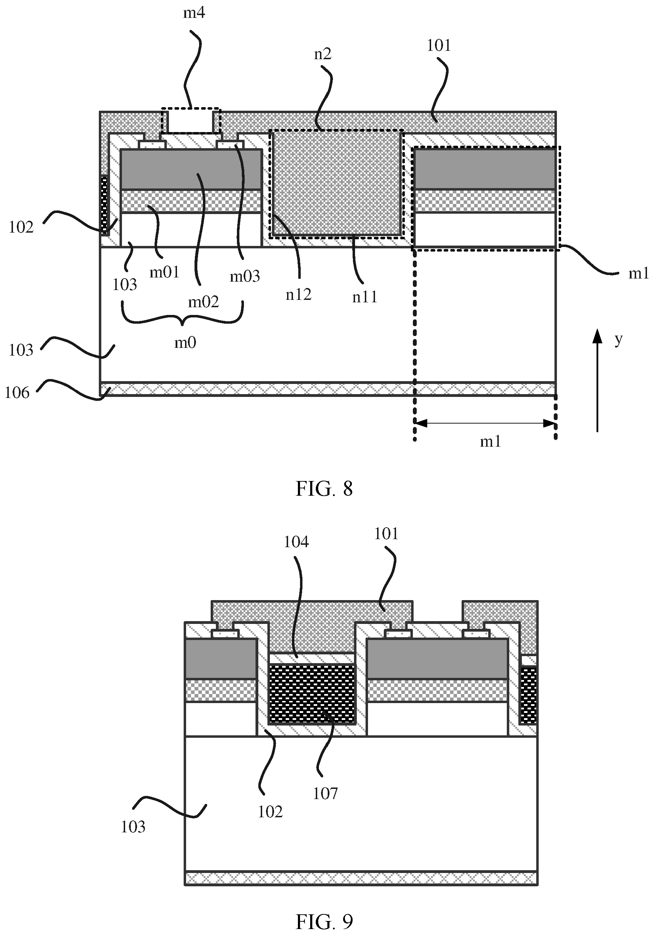

For example, with reference to FIG. 8, the light-emitting component may further include a peripheral structure m1. The peripheral structure m1 is disposed on the first semiconductor layer 103, the peripheral structure m1 is of an enclosed structure with internal accommodation space, and each light-emitting unit m0 is disposed in the accommodation space, so that the peripheral structure m1 encloses all of the light-emitting units m0. In this case, the second trench n2 may be formed in a region between the peripheral structure m1 and the light-emitting unit m0. In other words, the second trench n2 is formed in a region between a light-emitting unit m0 adjacent to the peripheral structure m1 and the peripheral structure m1. The first insulation layer 102 is disposed on each of a side that is of the peripheral structure m1 and that faces away from the first semiconductor layer 103, and a trench bottom n11 and a trench wall n12 of the second trench n2. In other words, the first insulation layer 102 covers a region that is of surfaces of the light-emitting unit m0, the peripheral structure m1, and the first semiconductor layer 103 and that is exposed and not covered by the light-emitting unit m0 and the peripheral structure m1. Correspondingly, the second electrode layer 101 may cover the first insulation layer 102 and the insulation filling portion 107, so that the second electrode layer 101 is entirely disposed. It should be understood that, that the second electrode layer 101 is entirely disposed may be understood as that the second electrode layer 101 is entirely disposed on the first semiconductor layer 103, so that each light-emitting unit m0, the peripheral structure m1, the first insulation layer 102, and the insulation filling portion 107 are all disposed between the first semiconductor layer 103 and the second electrode layer 101.

In addition, with reference to FIG. 8, structures of the light-emitting unit m0 and the peripheral structure m1 may be basically similar. For example, the light-emitting unit m0 and the peripheral structure m1 may each include the first semiconductor layer 103, a light-emitting layer m01, and a second semiconductor layer m02 that are stacked in a direction from the first electrode layer 106 to the second electrode layer 101, namely, a y direction. The light-emitting unit m0 may further include an auxiliary electrode m03 disposed on a surface on a side that is of the second semiconductor layer m02 and that faces away from the light-emitting layer m01. An auxiliary electrode m03 in each light-emitting unit m0 is connected to the second electrode layer 101, so that the light-emitting unit m0 is electrically connected to the second electrode layer 101. When the second electrode layer 101 is entirely disposed, to enable the light-emitting unit m0 to emit light outward, a plurality of openings m4 may be provided in the second electrode layer 101, the opening m4 is provided corresponding to the light-emitting unit m0, and each light-emitting unit m0 may emit light outward through a corresponding opening m4. There may be one or more openings m4 corresponding to each light-emitting unit m0. This is not limited herein, provided that the light-emitting unit m0 can emit light outward through the corresponding opening m4. Because the peripheral structure m1 does not need to emit light outward, there is no need to dispose the auxiliary electrode m03, and the second electrode layer 101 does not need to be provided with the opening m4 in a region in which the peripheral structure m1 is located, to simplify the structure of the light-emitting component.

For the light-emitting component, polarities of charges transmitted by the first semiconductor layer 103 and the second semiconductor layer m02 may be different. For example, the charge transmitted by the first semiconductor layer 103 may be a positive charge, and correspondingly, the charge transmitted by the second semiconductor layer m02 is a negative charge. In this case, the first semiconductor layer 103 may provide the positive charge for the light-emitting layer m01, the second semiconductor layer m02 may provide the negative charge for the light-emitting layer m01, and the positive charge and the negative charge meet in the light-emitting layer m01 to generate photons and emit light. Certainly, the charge transmitted by the first semiconductor layer 103 may alternatively be a negative charge, and correspondingly, the charge transmitted by the second semiconductor layer m02 is a positive charge. In this case, the first semiconductor layer 103 may provide the negative charge for the light-emitting layer m01, the second semiconductor layer m02 may provide the positive charge for the light-emitting layer m01, and the positive charge and the negative charge meet in the light-emitting layer m01 to generate photons and emit light. Manufacturing materials of the first semiconductor layer 103, the second semiconductor layer m02, and the light-emitting layer m01 may be selected according to an actual requirement. This is not limited herein. Any manufacturing material that can implement the first semiconductor layer 103, the second semiconductor layer m02, and the light-emitting layer m01 falls within the protection scope of this embodiment of this application.

In the light-emitting component, with reference to FIG. 9, a second insulation layer 104 may be further disposed between the second electrode layer 101 and the insulation filling portion 107, so that the insulation filling portion 107 is disposed between the first insulation layer 102 and the second insulation layer 104. When the insulation filling portion 107 is made of a polymer material, and the second insulation layer 104 is made of an inorganic insulating material, the second insulation layer 104 may increase a bonding force between the insulation filling portion 107 and the second electrode layer 101, to prevent the insulation filling portion 107 from being separated from the second electrode layer 101 due to a poor bonding force when the insulation filling portion 107 is in direct contact with the second electrode layer 101, so that the reliability of the light-emitting component can be improved. Certainly, when the first insulation layer 102 is made of an inorganic insulating material, the first insulation layer 102 may also increase a bonding force between the insulation filling portion 107 and the first semiconductor layer 103, to improve the reliability of the light-emitting component.

The first insulation layer 102 and the second insulation layer 104 may include a same manufacturing material, and the manufacturing material may be an inorganic insulating material, for example, but not limited to, SiN, SiO₂, or TiN. This may be specifically selected based on an actual situation, and is not limited herein. A manufacturing material of the insulation filling portion 107 may include an insulating material including at least one of C, O, and Si, for example, but not limited to, a polymer material or an inorganic insulating material. The polymer material may include but is not limited to polybenzoxazole, polyimide, benzocyclobutene, or the like, and the inorganic insulating material may include but is not limited to aluminum oxide, silicon oxynitride, silicate, nitrate, or the like. This may be specifically selected based on an actual situation, and is not limited herein.

For example, the thickness d1 of the insulation filling portion 107 may be set to 3 µm to 10 µm. The thickness d1 of the insulation filling portion 107 may be set based on factors such as a disposition position, a requirement for a breakdown voltage, and manufacturing costs. For example, if the requirement for the breakdown voltage is high, the thickness d1 of the insulation filling portion 107 may be set to be slightly larger. If the requirement for the breakdown voltage is low, but a requirement for the manufacturing costs is high, the thickness d1 of the insulation filling portion 107 may be set to be slightly smaller.

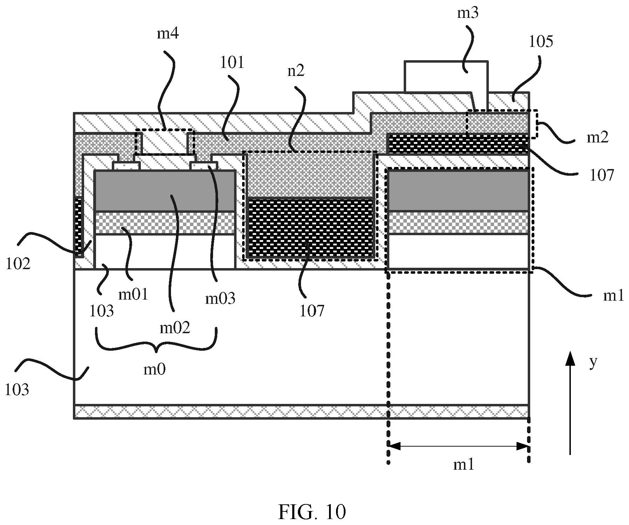

FIG. 10 is a diagram of an example of a structure of a light-emitting component according to an embodiment of this application. As shown in FIG. 10, the structure of the light-emitting component in this embodiment is basically similar to the foregoing structure of the light-emitting component in the first embodiment, and a difference lies in that: In addition to a case in which an insulation filling portion 107 is disposed in a first trench, the insulation filling portion 107 may also be disposed in a second trench n2, or the insulation filling portion 107 may also be disposed on a peripheral structure m1, or the insulation filling portion 107 may be disposed in the second trench n2 and on the peripheral structure m1.

For example, in addition to the case in which the insulation filling portion 107 is disposed in the first trench, when the insulation filling portion 107 is also disposed in the second trench n2, the insulation filling portion 107 is disposed on a surface on a side that is of a first insulation layer 102 in the second trench n2 and that faces away from a first semiconductor layer 103, and a second electrode layer 101 covers both the insulation filling portion 107 in the first trench and the insulation filling portion 107 in the second trench n2. Therefore, at a position of the second trench n2, a high reverse bias voltage can still be withstood by the first insulation layer 102 and the insulation filling portion 107 together. Even if the first insulation layer 102 formed in the second trench n2 has defects or poor deposition effect, presence of the insulation filling portion 107 can compensate for these defects and deficiencies, so that a capability of the first insulation layer 102 in the second trench n2 to withstand the high reverse bias voltage can be improved, thereby preventing breakdown of the first insulation layer 102 in the second trench n2, to further improve reliability of the light-emitting component.

In addition to the case in which the insulation filling portion 107 is disposed in the first trench, when the insulation filling portion 107 is also disposed on the peripheral structure m1, and when the second electrode layer 101 includes a connection electrode m2 disposed in a region in which the peripheral structure m1 is disposed, the light-emitting component further includes a control circuit m3, and the control circuit m3 is electrically connected to the connection electrode m2, the insulation filling portion 107 may also be disposed between the first insulation layer 102 disposed on the peripheral structure m1 and the connection electrode m2. In this way, the second electrode layer 101 can also cover the insulation filling portion 107, and a distance between the connection electrode m2 and the first insulation layer 102 can be further increased. The insulation filling portion 107 compensates for a defect and a deficiency in the first insulation layer 102 on the peripheral structure m1, so that a voltage can be withstood by the first insulation layer 102 and the insulation filling portion 107 together, to increase a capability of the first insulation layer 102 on the peripheral structure m1 to withstand the voltage, and prevent breakdown of the first insulation layer 102 on the peripheral structure m1, thereby further improving reliability of the light-emitting component.

If the control circuit m3 is disposed in the region in which the peripheral structure m1 is located, it indicates that the control circuit m3 and a light-emitting unit m0 are disposed on a same substrate. This can achieve an integrated design of the light-emitting component. In addition, because the peripheral structure m1 is not used for light emitting, the control circuit m3 is disposed in the region in which the peripheral structure ml is located. This can avoid occupying an area of a region in which the light-emitting unit m0 is located, thereby avoiding affecting light-emitting effect of the light-emitting component. Moreover, the control circuit m3 may be disposed on a side that is of the connection electrode m2 and that faces away from the peripheral structure m1, a third insulation layer 105 is disposed between the control circuit m3 and the connection electrode m2, and the control circuit m3 is electrically connected to the connection electrode m2 through a through hole in the third insulation layer 105, so that the control circuit m3 is electrically connected to the connection electrode m2.

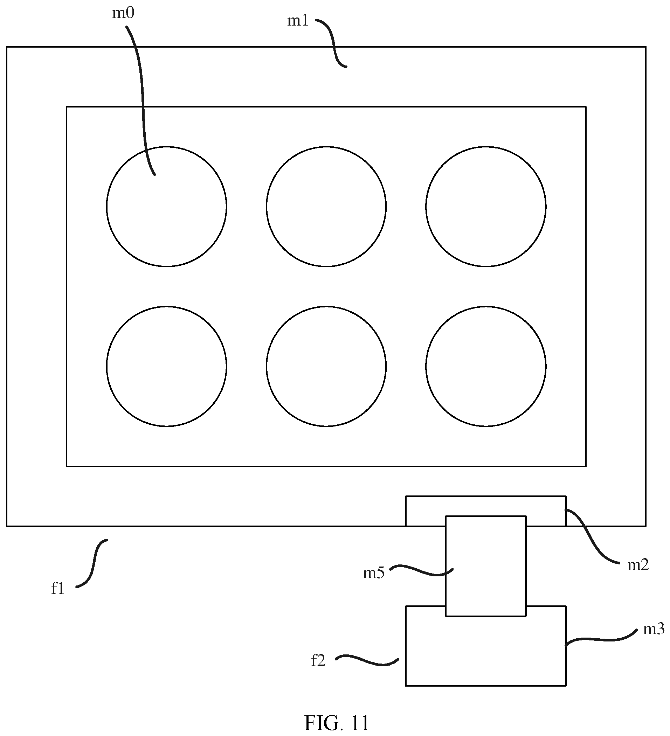

Alternatively, with reference to FIG. 11, the control circuit m3 and the light-emitting unit m0 may be disposed on different substrates. In other words, the light-emitting component may include a first part f1 and a second part f2. All the peripheral structure m1, the light-emitting unit m0, the first insulation layer (not shown in FIG. 11), the insulation filling portion (not shown in FIG. 11), the first electrode layer (not shown in FIG. 11), the second electrode layer (not shown in FIG. 11), and the first semiconductor layer (not shown in FIG. 11) may be disposed in the first part f1, and the control circuit m3 is disposed in the second part f2. In this way, the control circuit m3 may be prevented from occupying an area of the first part f1, so that more space of the first part f1 can be reserved for disposing the light-emitting unit m0, to improve a resolution of the light-emitting component. In this case, the first part f1 may be connected to the second part f2 through a chip on film m5 or another structure, so that the control circuit m3 is bound and connected to the connection electrode m2. Further, the connection electrode m2 may be a pad, and a structure form of the pad may be designed according to an actual requirement. This is not limited herein.

When the insulation filling portion 107 is disposed in the first trench, the second trench n2, and the peripheral structure m1, the reliability of the light-emitting component is tested. A test result is shown in Table 1 below. A probability that the light-emitting component is broken down at a high reverse bias voltage may be reduced to 0, to effectively resolve a problem of breakdown at the high reverse bias voltage.

**Table 1**

| Thickness of a first insulation layer | Amount of test samples | Probability of breakdown |
|---|---|---|
| 455 nm | 1192 | 0% |

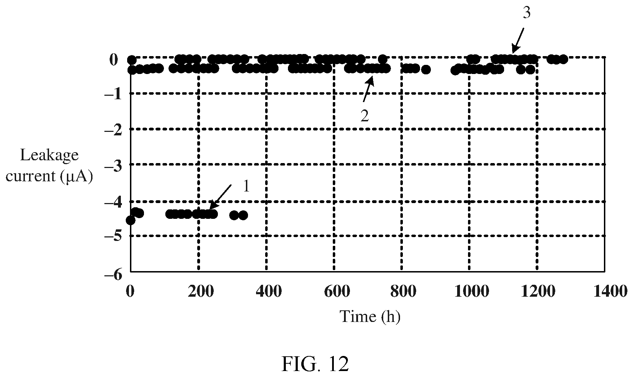

In addition, a reverse bias leakage current of the light-emitting component is tested, to obtain a test result shown in FIG. 12. A dot line indicated by an arrow 1 is a leakage current corresponding to a reverse bias voltage of -60 V, a dot line indicated by an arrow 2 is a leakage current corresponding to a reverse bias voltage of -50 V, a dot line indicated by an arrow 3 is a leakage current corresponding to a reverse bias voltage of -40 V, time represents time, hours represents a time unit for hour, and leakage current represents a leakage current. It can be learned from the result shown in FIG. 12 that, when the insulation filling portion 107 is disposed, even if the light-emitting component is in a reverse bias state, the leakage current is still small, and the leakage current does not increase with time. In other words, the leakage current remains constant with time. This indicates that the light-emitting component is not broken down, stability is good, and the reliability is high.

It should be understood that, for similarities between the light-emitting component in this embodiment and the light-emitting component in the first embodiment, refer to the light-emitting component described in the first embodiment. Repeated descriptions are not described again.

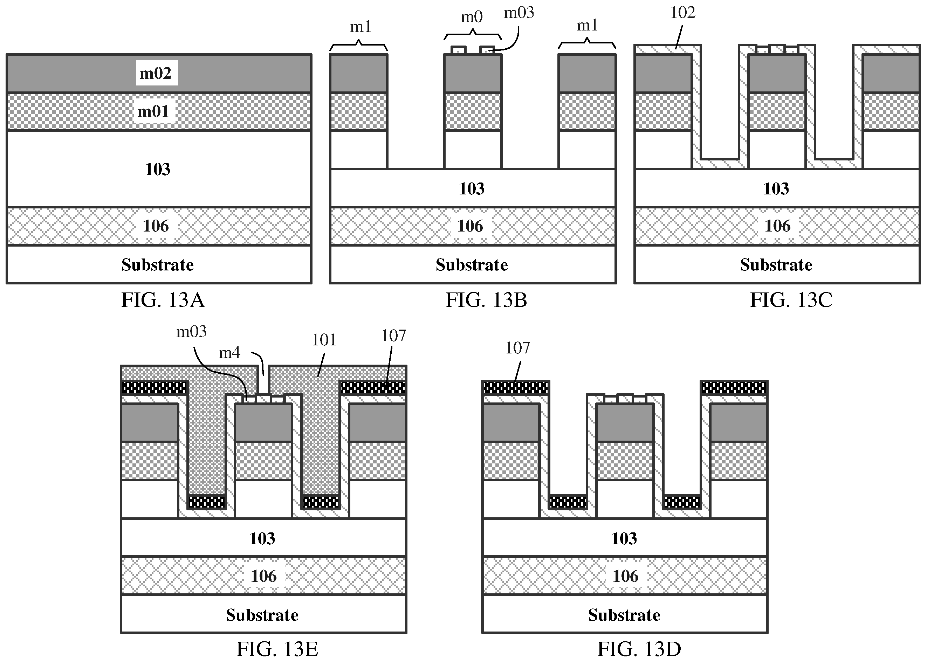

FIG 13A to FIG. 13E are a flowchart of an example of manufacturing a light-emitting component according to an embodiment of this application. As shown in FIG 13A to FIG. 13E, a manufacturing method for the light-emitting component may include the following steps.

Step S1: As shown in FIG. 13A, entirely form a first electrode layer 106 on a substrate by using a vapor deposition method.

Step S2: As shown in FIG. 13A, sequentially grow a first semiconductor layer 103, a light-emitting layer m01, and a second semiconductor layer m02 on the first electrode layer 106 by using an epitaxial growth technology, where the first semiconductor layer 103, the light-emitting layer m01, and the second semiconductor layer m02 may cover the entire first electrode layer 106.

Step S3: As shown in FIG. 13B, etch the second semiconductor layer m02, the light-emitting layer m01, and the first semiconductor layer 103 through dry etching or wet etching, to obtain a plurality of stacked columns and a peripheral structure ml through etching, where each stacked column and the peripheral structure m1 each include the first semiconductor layer 103, the light-emitting layer m01, and the second semiconductor layer m02 that are sequentially stacked in a direction from the first electrode layer 106 to the first semiconductor layer 103; and when etching the first semiconductor layer 103, reserve a part of the first semiconductor layer 103, to avoid exposing the first electrode layer 106.

Step S4: As shown in FIG. 13B, manufacture an auxiliary electrode m03 on the stacked column by using the vapor deposition method, to form a light-emitting unit m0, so that a first trench is formed in a region between two light-emitting units m0, and a second trench is formed in a region between the peripheral structure m1 and the light-emitting unit m0.

A cross-sectional shape of the light-emitting unit m0 on a surface parallel to the first electrode layer 106 may be a square as shown in FIG. 5, or may be a circle as shown in FIG. 11. Certainly, the cross-sectional shape may alternatively be in another shape, for example, an ellipse, a polygon, or an irregular shape. This may be specifically set according to an actual requirement, and is not limited herein.

It should be understood that, due to a view angle, only one light-emitting unit m0 is shown in FIG. 13B. However, this does not mean that the light-emitting component includes only the light-emitting unit m0. In addition, to avoid an excessively complex accompanying drawing, the first trench and the second trench are not shown in FIG. 13B.

Step S5: As shown in FIG. 13C, form a first insulation layer 102 on the first trench, the second trench, the light-emitting unit m0, and the peripheral structure m1 by using the vapor deposition method, where the auxiliary electrode m03 is exposed from the first insulation layer 102, so that the auxiliary electrode m03 is electrically connected to the second electrode layer.

Step S6: As shown in FIG. 13D, form, by using a liquid polymer material, an initial film in the first trench and the second trench and on the first insulation layer 102 of the peripheral structure m1 by using a spin coating method, and then perform curing processing on the initial film, so that the initial film is converted into a solid insulation filling portion 107.

Step S7: As shown in FIG. 13E, if a structure present after step S6 is performed is referred to as a semi-finished product, entirely deposit a conductive layer on a surface of the semi-finished product by using an electroplating method or the vapor deposition method, and perform patterning processing on the conductive layer, to obtain the second electrode layer 101 with an opening m4, where the opening m4 is provided corresponding to the light-emitting unit m0, the second electrode layer 101 is electrically connected to the auxiliary electrode m03, and the second electrode layer 101 covers the insulation filling portion 107.

In this way, the light-emitting component may be manufactured through the foregoing steps, and the manufactured light-emitting component has high reliability.

An example of a manufacturing method for a light-emitting component according to an embodiment of this application is shown. The manufacturing method in this embodiment is basically similar to the manufacturing method in the foregoing embodiment, and a difference lies in that step S6 in the foregoing embodiment is adjusted to: Form, by using an insulating material, an insulation filling portion in a first trench and a second trench and on a first insulation layer of a peripheral structure by using a vapor deposition method. In this way, the insulation filling portion can also be obtained by using the vapor deposition method, and the insulation filling portion can well fill a defect and a deficiency in the first insulation layer, thereby improving a voltage withstand capability of the first insulation layer and improving reliability of the light-emitting component.

It should be understood that, for similarities between the manufacturing method in this embodiment and the manufacturing method in the foregoing embodiment, refer to the descriptions of the manufacturing method in the foregoing embodiment. Repeated descriptions are not described again.

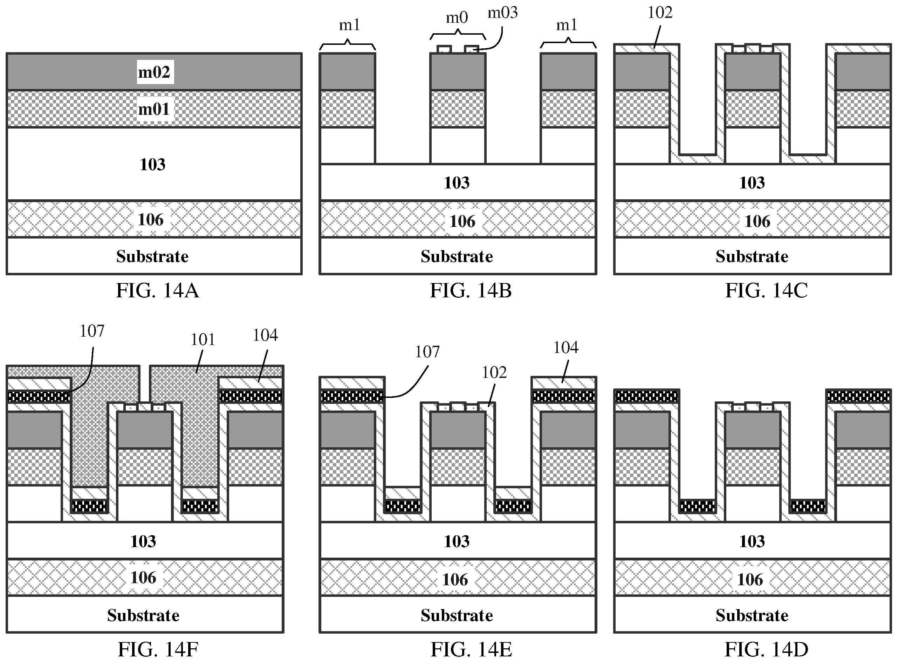

FIG 14A to FIG. 14F are a flowchart of an example of manufacturing a light-emitting component according to an embodiment of this application. As shown in FIG 14A to FIG. 14F, a manufacturing method in this embodiment is basically similar to the manufacturing method in the foregoing embodiment, and a difference lies in that step S8 is added after step S6 and before step S7. For example, step S8 includes: As shown in FIG. 14E, form a second insulation layer 104 on an insulation filling portion 107 by using a vapor deposition method, so that the insulation filling portion 107 is disposed between a first insulation layer 102 and the second insulation layer 104, and further, as shown in FIG. 14F, the insulation filling portion 107 is in contact with a second electrode layer 101 through the second insulation layer 104, to improve bonding strength of the insulation filling portion 107 and the second electrode layer 101, thereby improving reliability of the light-emitting component. It should be understood that, for similarities between the manufacturing method in this embodiment and the manufacturing method in the foregoing embodiment, refer to the descriptions of the manufacturing method in the foregoing embodiment. Repeated descriptions are not described again.

It is clear that a person skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A light-emitting component, comprising: a first electrode layer, a first semiconductor layer disposed on the first electrode layer, and a light-emitting unit, a first insulation layer, an insulation filling portion, and a second electrode layer that are disposed on the first semiconductor layer, wherein
there are a plurality of light-emitting units that are spaced apart, the light-emitting unit is electrically connected to the second electrode layer, a first trench is formed in a region between two light-emitting units, and the first insulation layer is disposed on each of a trench bottom and a trench wall of the first trench and a side that is of the light-emitting unit and that faces away from the first semiconductor layer; and
the insulation filling portion is disposed on a surface on a side that is of the first insulation layer in the first trench and that faces away from the first semiconductor layer, and the second electrode layer covers the insulation filling portion.

2. The light-emitting component according to claim 1, further comprising a peripheral structure disposed on the first semiconductor layer, wherein the peripheral structure encloses all of the light-emitting units; and
a second trench is formed in a region between the peripheral structure and the light-emitting unit, the first insulation layer is disposed on each of a side that is of the peripheral structure and that faces away from the first semiconductor layer, and a trench bottom and a trench wall of the second trench, and the insulation filling portion is disposed on a surface on a side that is of the first insulation layer in the second trench and that faces away from the first semiconductor layer.

3. The light-emitting component according to claim 2, wherein the second electrode layer comprises a connection electrode disposed in a region in which the peripheral structure is located;
the light-emitting component further comprises a control circuit, and the control circuit is electrically connected to the connection electrode; and
the insulation filling portion is disposed between the first insulation layer and the connection electrode.

4. The light-emitting component according to claim 3, wherein the control circuit is disposed in the region in which the peripheral structure is located, and the control circuit is disposed on a side that is of the connection electrode and that faces away from the peripheral structure.

5. The light-emitting component according to claim 3, wherein the connection electrode is bound and connected to the control circuit.

6. The light-emitting component according to claim 5, wherein the connection electrode is a pad.

7. The light-emitting component according to any one of claims 2 to 6, wherein the light-emitting unit and the peripheral structure each comprise the first semiconductor layer, a light-emitting layer, and a second semiconductor layer that are stacked in a direction from the first electrode layer to the second electrode layer;
the light-emitting unit further comprises an auxiliary electrode disposed on a surface on a side that is of the second semiconductor layer and that faces away from the light-emitting layer;
the second electrode layer is entirely disposed, the second electrode layer has a plurality of openings, the opening is provided corresponding to the light-emitting unit, and each light-emitting unit emits light outward through a corresponding opening;
the auxiliary electrode in each light-emitting unit is connected to the second electrode layer; and
polarities of charges transmitted by the first semiconductor layer and the second semiconductor layer are different.

8. The light-emitting component according to any one of claims 1 to 7, wherein a second insulation layer is further disposed between the second electrode layer and the insulation filling portion.

9. The light-emitting component according to claim 8, wherein the first insulation layer and the second insulation layer comprise a same manufacturing material.

10. The light-emitting component according to any one of claims 1 to 9, wherein a manufacturing material of the insulation filling portion comprises an insulating material comprising at least one of C, O, or Si.

11. A method for manufacturing the light-emitting component according to any one of claims 1 to 10, comprising:
forming the first electrode layer;
forming the first semiconductor layer on the first electrode layer;
forming, on the first semiconductor layer, the plurality of light-emitting units that are spaced apart, and forming the first trench in the region between two light-emitting units;
forming the first insulation layer at least on the trench bottom and the trench wall of the first trench and the light-emitting unit;
forming the insulation filling portion at least on the first insulation layer in the first trench; and
forming the second electrode layer, so that the second electrode layer covers the insulation filling portion, and the second electrode layer is electrically connected to the light-emitting unit.

12. The method according to claim 11, wherein forming the insulation filling portion comprises:
depositing a liquid insulating material at least on the first insulation layer in the first trench, to form an initial film; and
performing curing processing on the initial film, to form the solid insulation filling portion.

13. The method according to claim 11, wherein forming the insulation filling portion comprises:
depositing an insulating material at least on the first insulation layer in the first trench by using a vapor deposition method, to form the solid insulation filling portion.

14. The method according to any one of claims 11 to 13, further comprising:
when the light-emitting unit is formed, forming the peripheral structure enclosing all of the light-emitting units; and
forming the insulation filling portion comprises: when the second trench in the region between the peripheral structure and the light-emitting unit is formed, and the first insulation layer is further disposed on the peripheral structure and the trench bottom and the trench wall of the second trench, forming the insulation filling portion on the first insulation layer in the first trench and the second trench and on at least a part of the first insulation layer located in the region in which the peripheral structure is located.

15. The method according to any one of claims 11 to 14, further comprising:
before the second electrode layer is formed, forming the second insulation layer on the insulation filling portion.

16. A radar, comprising a detector, a controller, and the light-emitting component according to any one of claims 1 to 10, wherein
the light-emitting component is configured to transmit an electromagnetic wave to a target under control of the controller;
the detector is configured to: receive an echo reflected from the target and transmit the echo to the controller; and
the controller is configured to determine information about the target based on the electromagnetic wave transmitted by the light-emitting component and the echo detected by the detector.

17. An electronic device, comprising a control device and the radar according to claim 16, wherein the radar is disposed on the control device.
